# FASCICULE DE BREVET EUROPEEN

(11) **EP 1 801 897 B1**
(45) Date de publication et mention de la délivrance du brevet: **10.03.2010**
(21) Numéro de dépôt: 06126684.7
(22) Date de dépôt: 20.12.2006
(51) Int. Cl.: H01L 45/00

(54) **Procédé amélioré de réalisation de cellules mémoires de types PMC**
Verbessertes Verfahren zur Herstellung von Speicherzellen vom Typ PMC
Improved method of producing PMC type memory cells

(30) Priorité: 23.12.2005 FR 0513258
(43) Date de publication de la demande: 27.06.2007
(73) Titulaire: COMMISSARIAT A L'ENERGIE ATOMIQUE, 75015 Paris (FR)
(72) Inventeur: Dressler, Cyril, 38210 Tullins (FR); Sousa, Véronique, 38000 Grenoble (FR)
(74) Mandataire: Poulin, Gérard

(56) Documents cités:
- US-A1- 2003 045 049
- US-A1- 2004 192 006
- US-A1- 2005 162 907

## Description

### DOMAINE TECHNIQUE

La présente invention se rapporte au domaine de la microélectronique et plus particulièrement à celui des dispositifs microélectroniques, tels que les mémoires, doté(e)s d'une ou plusieurs éléments ou cellules de type PMC (PMC pour « Programmable Metallization Cell »), lesdites cellules comprenant respectivement, au moins deux électrodes, et un empilement de couches minces entre les électrodes, ledit empilement comportant au moins une couche destinée à servir d'électrolyte solide, qui peut être à base d'au moins un chalcogénure dopé par exemple par des particules métalliques.

L'invention concerne en particulier un procédé microélectronique amélioré de fabrication d'élément(s) de type PMC, comprenant la réalisation de moyens pour empêcher la formation d'agglomérats métalliques sur l'électrolyte solide. Le procédé suivant l'invention permet également de se prémunir d'une étape de photodiffusion pour doper la couche de chalcogénure. L'invention concerne également un dispositif microélectronique doté de cellules PMC améliorées.

### ART ANTÉRIEUR

Le fonctionnement des dispositifs de type PMC est basé sur la formation, au sein d'un électrolyte solide, d'éléments métalliques appelés « dendrites » entre deux électrodes, lorsque ces électrodes sont portées à des potentiels respectifs appropriés. La formation des dendrites permet d'obtenir une conduction électrique donnée entre les deux électrodes. En modifiant les potentiels respectifs appliqués aux électrodes, il est possible de modifier la répartition et le nombre des dendrites, et de modifier ainsi la conduction électrique entre les deux électrodes. En inversant par exemple le potentiel entre les électrodes, il est possible de faire disparaître ou de réduire les dendrites, de manière à supprimer ou à réduire considérablement la conduction électrique due à la présence des dendrites. Les cellules PMC peuvent ainsi avoir un fonctionnement à deux états : un état dit « ON » et un état dit « OFF » et jouer par exemple le rôle de cellules mémoires.

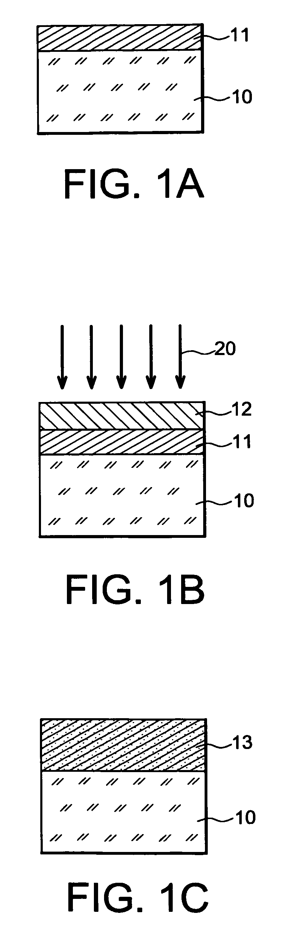

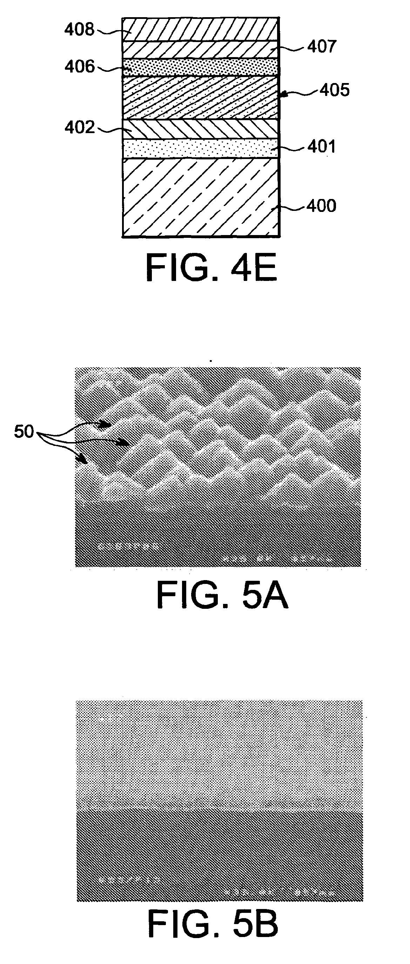

Le document US 5 761 115 présente plusieurs variantes d'un dispositif microélectronique suivant l'art antérieur, doté d'au moins une cellule de type PMC, ainsi qu'un procédé de réalisation de ce dispositif. Les figures 1A à 1C illustrent un tel procédé. Sur un substrat 10 par exemple à base de silicium, ou de verre, ou de plastique, on effectue tout d'abord un dépôt d'une première couche 11 destinée à servir de conducteur ionique ou d'électrolyte solide. Cette première couche 11 peut être à base d'au moins un chalcogénure, par exemple du GeSe, et réalisée par exemple par évaporation sous vide (figure 1A). Puis, une deuxième couche 12 dite « de dopant », est formée sur la première couche 11. La deuxième couche 12 peut être métallique, par exemple à base d'argent et réalisée par dépôt par évaporation sous vide. Ensuite, une étape de photodissolution (figure 1B), à l'aide de rayons UV 20, du métal de la deuxième couche 12 dans la première couche 11, est effectuée. A l'issu de cette photodissolution, une couche de matériau conducteur ionique 13, par exemple à base d'un chalcogénure dopé par des particules, c'est-à-dire des atomes ou des groupements d'atomes d'argent, est formée (figure 1C). Avec un tel procédé, des agglomérats de métal, par exemple d'argent ont tendance à se former en surface de la couche à base de chalcogénure. De tels agglomérats 50 nuisent au fonctionnement de la cellule, et sont illustrés par exemple sur la figure 5A.

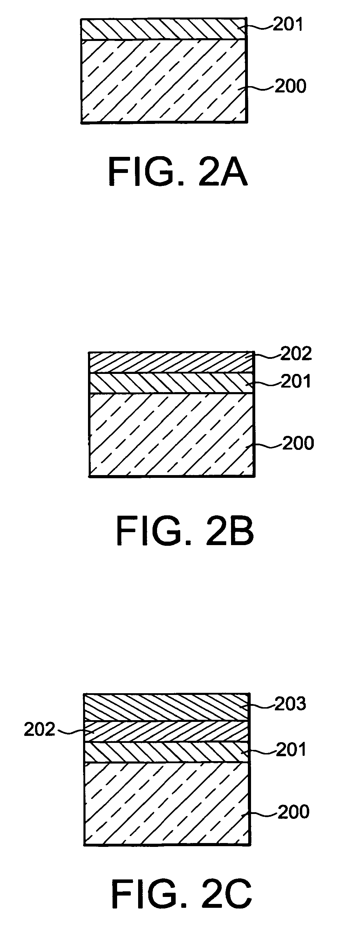

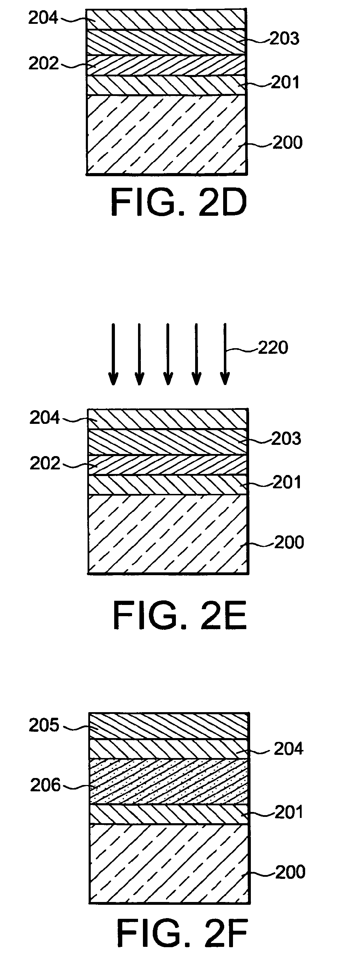

Une solution au problème de formation des agglomérats métalliques en surface de la couche à base de chalcogénure, est proposée dans le document US 6 878 569 B2. Ce document divulgue également un procédé microélectronique de réalisation d'un dispositif microélectronique doté d'au moins un élément de type PMC. Dans ce procédé on forme tout d'abord sur un substrat 200, une première électrode métallique 201, par exemple par dépôt (figure 2A). Puis, sur cette première électrode 201, une couche 202 à base de chalcogénure, par exemple du GeSe, est ensuite formée (figure 2B). Puis, sur la couche 202 à base de chalcogénure, on dépose une couche destinée à doper le chalcogénure, telle qu'une couche 203 à base d'au moins un matériau métallique, par exemple de l'argent (figure 2C). Une couche barrière 204 de composition identique à celle de la couche de chalcogénure 202 est ensuite déposée sur la couche 203 de matériau métallique (figure 2D). Puis, une photodissolution dudit matériau métallique est réalisée à l'aide de rayons UV 220 (figure 2E). La photodissolution conduit à la formation d'une couche de conducteur ionique 206 à base de chalcogénure dopé par des particules métalliques. Ensuite, une deuxième électrode 205, par exemple en argent, est formée sur la couche barrière 204 (figure 2F).

Au cours d'un tel procédé, l'étape de photodissolution précédemment décrite, est réalisée généralement à l'aide d'une couche de dopant métallique, par exemple une couche d'argent, d'épaisseur très fine, et limitée afin de permettre le passage des rayons UV. Cette épaisseur limitée, confère à la cellule PMC ainsi fabriquée, un champ d'applications réduit. La photodissolution pose également dans certains cas des problèmes de précision du dopage de la couche de chalcogénure. La photodissolution requiert également l'utilisation d'appareils spécifiques et ajoute une étape au procédé de réalisation de la cellule PMC.

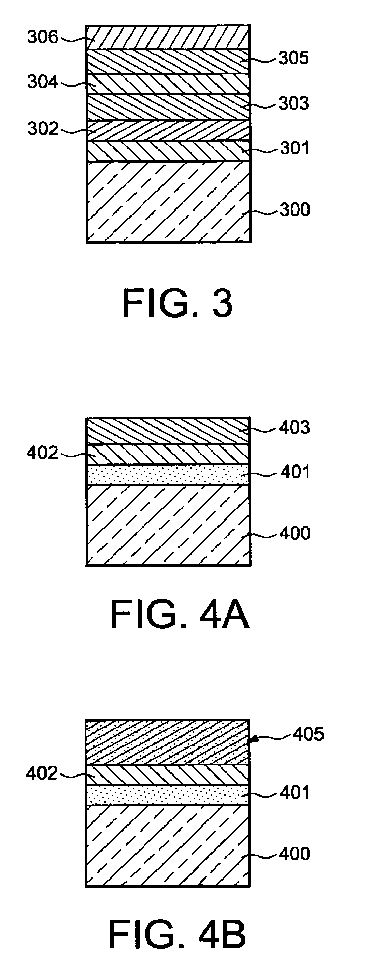

Le document US 6,864,521 B2 divulgue quant à lui, une variante de procédé de réalisation d'une cellule de type PMC, comprenant des étapes de formation d'une première électrode 301 sur un substrat 300, puis de formation d'une première couche à base de chalcogénure 302, par exemple du GeSe, sur la première électrode 301, puis de réalisation d'une première couche 303 dite « de dopant » à base de chalcogénure et d'un matériau, par exemple métallique, apte à doper la première couche 302 de chalcogénure. La couche 303 de dopant peut être à base de AgSe. Une deuxième couche 304 à base de chalcogénure, par exemple à base de GeSe est ensuite réalisée sur la couche 303 de dopant, puis une deuxième couche 305 de dopant, à base d'un matériau métallique, par exemple de l'argent, est formée sur la deuxième couche 304 à base de chalcogénure. Ensuite, une deuxième électrode 306, est formée sur la deuxième couche 305 de dopant (figure 3). Un tel procédé a pour inconvénient de mettre en oeuvre un nombre important d'étapes pour former l'électrolyte solide. Le document D1 (2004/0192006 A1) divulgue un procédé de réalisation d'un dispositif microélectronique comportant une première électrode formée d'une couche de chalcogénure dopée, une deuxième électrode, et une pluralité de couches minces entre la première électrode et la deuxième électrode, dont au moins une couche formant un électrolyte solide. Sur la couche de chalcogénure dopée, une couche à base d'AgSe en contact avec la couche de chalcogénure dopée est réalisée, tandis que sur, et contact avec, la couche à base d'AgSe une autre couche métallique « donneuse d'ions » est formée..

Il se pose le problème de trouver un nouveau procédé de réalisation d'un dispositif microélectronique doté de cellules de types PMC, qui ne comporte pas les inconvénients évoqués ci-dessus.

### EXPOSÉ DE L'INVENTION

L'invention concerne tout d'abord un procédé de réalisation d'un dispositif microélectronique doté d'une ou plusieurs cellules ou éléments comportant respectivement : au moins une première électrode, au moins une deuxième électrode, et au moins une couche mince apte à former un électrolyte solide entre la première électrode et la deuxième électrode, le procédé comprenant les étapes de :
a) réalisation sur au moins une première couche conductrice destinée à former ladite première électrode, d'au moins une couche de chalcogénure dopée destinée à former ledit électrolyte solide,
b) formation sur la couche de chalcogénure dopée, d'au moins une couche, dite « d'interface », à base d'un matériau donné différent dudit chalcogénure,
c) formation sur la couche d'interface d'au moins une couche métallique dite « donneuse d'ions », destinée à former une source d'ions pour ledit électrolyte solide.

Ledit matériau donné est du carbone ou du carbone comportant un additif métallique, par exemple de l'Argent, ou semi-conducteur, par exemple du Si. Un tel matériau permet de former une couche d'interface de faible épaisseur, tout en ayant une bonne continuité et une épaisseur homogène, et en conférant à la cellule PMC de bonnes propriétés électriques.

La couche d'interface a une composition et une épaisseur autorisant la diffusion d'ions métalliques issus d'une couche donneuse d'ions dans la couche de chalcogénure dopée.

La réalisation de la couche d'interface permet notamment d'éviter la formation d'agglomérats à la surface de l'électrolyte solide.

Ladite couche d'interface peut avoir une épaisseur comprise entre 1 et 10 nanomètres, de préférence entre 1 et 5 nanomètres.

Selon une possibilité, la formation de ladite couche de chalcogénure dopée peut comprendre :
- le dépôt d'au moins une couche à base d'au moins un chalcogénure,
- le dépôt par pulvérisation cathodique d'une fine couche métallique sur ladite couche de chalcogénure.

Le dépôt par pulvérisation cathodique de ladite fine couche métallique sur ladite couche de chalcogénure permet une répartition homogène de l'espèce métallique dopante dans le chalcogénure sans nécessiter d'étape de photodissolution, et en utilisant par exemple des équipements standards de l'industrie microélectronique.

Selon une possibilité, qui peut être combinée avec la précédente, ladite couche d'interface peut être formée par pulvérisation cathodique. Ladite couche d'interface peut être éventuellement formée par pulvérisation cathodique dans un même réacteur ou une même chambre de dépôt que la couche de chalcogénure dopée.

Selon une autre possibilité qui peut être combinée avec les précédentes, ladite couche métallique « donneuse d'ions » peut être formée par pulvérisation cathodique. Ladite couche métallique « donneuse d'ions » peut être éventuellement formée par pulvérisation cathodique dans un même réacteur ou une même chambre que la couche de chalcogénure dopée ou/et que la couche d'interface.

Le procédé peut également comprendre : la formation sur, et en contact avec, la couche métallique donneuse d'ions, de la deuxième électrode, à base d'un matériau métallique différent de celui ladite couche métallique donneuse d'ions.

Selon une variante, la couche métallique donneuse d'ions peut être réalisée avec une épaisseur suffisante pour pouvoir jouer le rôle de deuxième électrode.

L'invention concerne également un dispositif microélectronique doté d'une ou plusieurs cellules ou éléments comportant respectivement : au moins une première électrode, au moins une deuxième électrode, et au moins un empilement de couches minces entre la première électrode et la deuxième électrode, ledit empilement comprenant :
- au moins une couche de chalcogénure dopée, apte à former un électrolyte solide, sur et en contact de la première électrode,
- au moins une couche, dite « d'interface », sur et en contact de ladite couche de chalcogénure dopée, et à base d'un matériau donné différent dudit chalcogénure,
- au moins une couche métallique dite « donneuse d'ions », sur et en contact de ladite couche « d'interface », et destinée à former une source d'ions pour ledit électrolyte solide.

Ledit matériau donné est du carbone ou du carbone comportant un additif métallique ou semi-conducteur.

L'invention concerne également un dispositif de mémoire comprenant un dispositif microélectronique tel que défini précédemment.

La couche d'interface peut permettre de former des cellules mémoires de type PMC dotées d'une meilleure cyclabilité, ou d'une robustesse vis-à-vis d'un nombre important de changement d'état, ou d'écriture/effacement, que les cellules mémoires suivant l'art antérieur.

Ladite couche d'interface peut avoir une épaisseur comprise entre 1 et 10 nanomètres.

Selon une possibilité de mise en oeuvre du dispositif, ladite couche métallique « donneuse d'ions » peut appartenir à ladite deuxième électrode.

Selon une variante, ladite deuxième électrode reposant sur ladite couche métallique « donneuse d'ions ».

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1C, 2A-2F, et 3 déjà décrites, illustrent des procédés de réalisation de cellules PMC suivant l'art antérieur,
- les figures 4A-4E illustrent différentes étapes d'un exemple de procédé suivant l'invention, de réalisation d'un dispositif microélectronique doté d'au moins une cellule PMC améliorée,
- la figure 5A illustre les phénomènes d'agglomérats métalliques dans un empilement de couches minces tel que mis en oeuvre dans une cellule PMC suivant l'art antérieur,
- la figure 5B illustre une vue en coupe d'un empilement de couches minces mis en oeuvre dans d'une cellule PMC mise en oeuvre suivant l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un exemple de procédé microélectronique suivant l'invention, va à présent être donné en liaison avec les figures 4A à 4F. Ce procédé a pour but la réalisation d'un dispositif microélectronique, par exemple une mémoire, doté(e) d'au moins une cellule ou élément de type PMC, la cellule ou l'élément étant formé(e) d'un empilement de couches minces entre au moins une première électrode et au moins une deuxième électrode, comportant au moins une couche, à base d'au moins un chalcogénure dopé, par exemple par des particules métalliques, apte à former un électrolyte solide ou un conducteur d'ions.

Le matériau de départ du procédé peut être un support, comprenant par exemple une couche de matériau isolant 401, par exemple du SiO₂ reposant sur un substrat 400 qui peut être semi-conducteur, par exemple à base de silicium. Une première couche conductrice 402 destinée à former une première électrode ou « électrode inférieure », par exemple à base de nickel ou de tungstène, est ensuite réalisée sur la couche 401 dudit support. La formation de la première électrode pourra être complétée par exemple par des étapes de photolithographie, puis gravure de la première couche conductrice 402.

Ensuite, une couche 403 à base d'au moins un chalcogénure est formée sur et en contact de la première couche conductrice 402 (figure 4A). La couche 403 à base d'au moins un chalcogénure peut être réalisée par dépôt par évaporation sous vide ou par pulvérisation cathodique, et peut avoir une épaisseur par exemple comprise entre 10 et 100 nanomètres, par exemple de l'ordre de 50 nanomètres. Ledit chalcogénure peut être par exemple du GeₓSe_{y}, par exemple dans une stoechiométrie telle que x = 25 et y = 75.

Puis, sur, et en contact avec, la couche de chalcogénure 403, une fine couche de dopant (non référencée), par exemple métallique est déposée. La fine couche de dopant peut être également réalisée par dépôt par pulvérisation cathodique. La fine couche de dopant peut être par exemple à base d'argent. La fine couche de dopant peut avoir une épaisseur comprise par exemple entre 2 et 50 nanomètres, ou par exemple de l'ordre de 1/3 de l'épaisseur de la couche 403 de chalcogénure. Selon une possibilité, la fine couche de dopant peut être réalisée dans la même chambre de dépôt que la couche de chalcogénure 403. Une formation de la fine couche de dopant 404 par pulvérisation cathodique, permet une diffusion du dopant métallique, par exemple de l'argent, directement dans la couche 403 de chalcogénure, par exemple dans le GeₓSe_{y}, de manière à former une couche 405 à base de chalcogénure, dopée par des particules métalliques. La couche 405 à base de chalcogénure dopé, pourra jouer le rôle d'un électrolyte solide (figure 4B).

Selon une variante, la couche de chalcogénure dopé 405 peut être obtenue par dépôt par évaporation sous vide d'une couche à base de chalcogénure, puis par dépôt par évaporation sous vide d'une fine couche de dopant, puis par exposition de la fine couche de dopant à des rayons UV. Avantageusement, la couche de chalcogénure dopée 405 est réalisée par dépôt par pulvérisation cathodique d'une couche à base de chalcogénure, puis par dépôt par pulvérisation cathodique d'une fine couche de dopant sur la couche de chalcogénure.

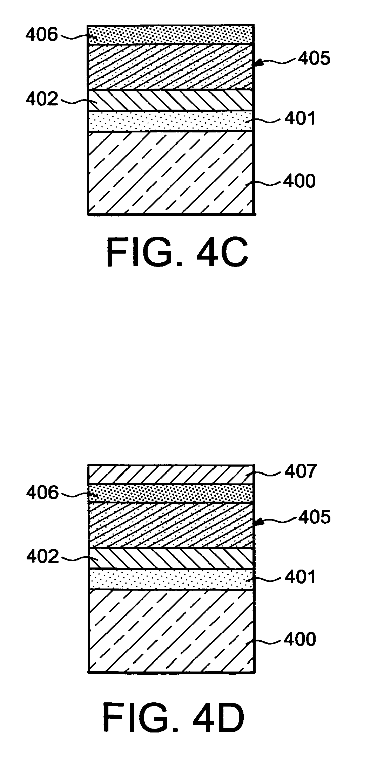

Ensuite (figure 4C), on réalise des moyens pour empêcher la formation d'agrégats métalliques sur la couche 405 de chalcogénure dopée. Ces moyens peuvent être sous forme d'une couche d'interface 406 que l'on dépose sur la couche 405 de chalcogénure dopé.

La couche d'interface 406 est formée à base d'un matériau donné en contact avec le chalcogénure, et qui ne diffuse pas dans la couche 405 de chalcogénure dopée. La couche d'interface 406 est formée à base d'un matériau donné différent de ce chalcogénure.

Ce matériau donné est un matériau choisi de manière à ce que la couche intermédiaire même dotée d'une très fine épaisseur, par exemple entre 1 et 10 nanomètres, abaisse la tension de surface de la couche 405 formant un électrolyte solide et peut empêcher ainsi la formation d'agrégats métalliques. Ce matériau donné peut également être choisi de manière à ce que la couche intermédiaire 406, même dotée d'une très fine épaisseur par exemple comprise entre 1 et 10 nanomètres, soit continue ou/et présente une faible rugosité, par exemple inférieure à 1 nanomètres ou à 0,5 nanomètres, de préférence inférieure à 0,3 nanomètres. Le matériau donné est du carbone, ou du carbone comportant un additif, par exemple métallique, tel que du cuivre ou de l'argent, ou par exemple semi-conducteur tel que du Si. La couche d'interface 406 peut être formée à base d'un matériau dont la résistivité est comprise entre 1 et 1000 Ω*cm⁻¹, en couche mince.

La couche d'interface 406 peut être avantageusement réalisée dans la même chambre de dépôt que la couche 403 de chalcogénure et éventuellement que la fine couche de dopant 404. La couche d'interface 406 a une épaisseur qui peut être comprise par exemple entre 1 et 10 nanomètres, ou entre 1 et 5 nanomètres, par exemple de l'ordre de 2 nanomètres.

Puis (figure 4D), on forme sur la couche d'interface 406, au moins une couche 407 susceptible d'effectuer des échange de matière sous forme d'ions, dite de « source d'ions » ou « donneuse d'ions », qui peut être métallique, et destinée à fournir des ions métalliques à la couche 405 formant l'électrolyte solide. La couche métallique 407 « donneuse d'ions » a une composition différente ou est formée d'un ou plusieurs matériaux différents de celui ou de ceux de la couche 406 d'interface. La couche 407 donneuse d'ions, peut être par exemple à base d'argent, et d'épaisseur comprise par exemple entre 2 et 50 nanomètres, par exemple de l'ordre de 10 nanomètres. La couche 407 donneuse d'ions peut être réalisée par pulvérisation cathodique. Selon une mise en oeuvre possible du procédé, la couche 407 donneuse d'ions peut être réalisée dans la même chambre de dépôt que la couche d'interface 406 et/ou que la couche de dopant 404 et/ou que la couche 403 de chalcogénure.

Ensuite, une deuxième électrode peut être formée sur la couche métallique 407 donneuse d'ions. La formation de la deuxième électrode peut comprendre une étape de dépôt d'une deuxième couche conductrice 408, par exemple à base d'un métal différent de celui de la couche 407, tel que du Ni ou du Al (figure 4E). La deuxième couche conductrice 408 peut avoir une épaisseur comprise par exemple entre 100 et 500 nanomètres. Des étapes de photolithographie, puis de gravure pourront par exemple être également réalisées pour compléter la formation de ladite deuxième électrode.

Selon une variante (non représentée), après formation de la couche d'interface 406, la couche métallique 407 source d'ions, par exemple à base d'argent, est formée avec une épaisseur suffisante, par exemple comprise entre 100 et 500 nanomètres, pour jouer le rôle de deuxième électrode.

A l'aide du procédé, les étapes de formation de la couche de chalcogénure, de formation d'un électrolyte solide 405 par dopage dudit chalcogénure, de formation de la couche d'interface 406, et éventuellement de formation de la couche donneuse d'ions 407 peuvent être effectuées dans une même machine de dépôt, sans qu'il soit nécessaire de mettre en oeuvre une étape de photodiffusion.

Sur la figure 5A, est donnée une image MEB (MEB pour microscope électronique à balayage) d'une vue en coupe d'un empilement technologique de couches minces mis en oeuvre lors de la fabrication d'une cellule PMC suivant l'art antérieur, et qui ne comporte pas de couche intermédiaire entre la couche métallique source d'ions et la couche de chalcogénure. Sur cette figure, des agglomérats métalliques 50 sont formés sur la couche de chalcogénure. La figure 5B illustre quant à elle une vue en coupe d'un empilement technologique de couches minces mis en oeuvre lors de la fabrication d'une cellule PMC suivant l'invention, et dans laquelle figure une couche intermédiaire entre la couche de chalcogénure dopée servant d'électrolyte solide et la couche métallique donneuse d'ions.

## Revendications

1. Procédé de réalisation d'un dispositif microélectronique doté d'une ou plusieurs cellules ou éléments comportant respectivement : au moins une première électrode, au moins une deuxième électrode, et au moins une couche mince apte à former un électrolyte solide entre la première électrode et la deuxième électrode, le procédé comprenant les étapes de :
a) réalisation sur au moins une première couche conductrice (402) destinée à former ladite première électrode, d'au moins une couche de chalcogénure (405) dopée destinée à former ledit électrolyte solide,
b) formation sur, et en contact avec, la couche (405) de chalcogénure dopée, d'au moins une couche (406), dite d'interface, à base d'un matériau donné différent dudit chalcogénure,
c) formation sur, et en contact avec, la couche d'interface (406) d'au moins une couche métallique (407) dite « donneuse d'ions », destinée à former une source d'ions pour ledit électrolyte solide,
le procédé étant **caractérisé en ce que** ledit matériau donné de la couche d'interface est du carbone ou du carbone comportant un additif métallique ou semi-conducteur.

2. Procédé selon la revendication 1, ladite couche d'interface (406) ayant une épaisseur comprise entre 1 et 10 nanomètres.

3. Procédé selon la revendication 1 ou 2, ladite couche métallique « donneuse d'ions » (407) ou/et ladite couche d'interface (406) étant formée(s) par pulvérisation cathodique.

4. Procédé selon l'une des revendications 1 à 3, la formation de ladite couche de chalcogénure (405) dopée comprenant :
- le dépôt d'au moins une couche (403) à base d'au moins un chalcogénure,
- le dépôt par pulvérisation cathodique d'une fine couche métallique (405) sur ladite couche de chalcogénure.

5. Procédé selon l'une des revendications 1 à 4, comprenant en outre : la formation sur, et en contact avec, la couche métallique (407) donneuse d'ions, de la deuxième électrode (408), à base d'un matériau métallique différent de celui de ladite couche métallique (407) donneuse d'ions.

6. Dispositif microélectronique doté d'une ou plusieurs cellules ou éléments comportant respectivement : au moins une première électrode, au moins une deuxième électrode, et au moins un empilement de couches minces entre la première électrode et la deuxième électrode, ledit empilement comprenant :
- au moins une couche de chalcogénure (405) dopée, apte à former un électrolyte solide, sur et en contact avec, la première électrode (404),
- au moins une couche (406), dite « d'interface », sur et en contact avec, ladite couche de chalcogénure (405) et à base d'un matériau donné différent dudit chalcogénure,
- au moins une couche métallique (407) dite « donneuse d'ions », sur et en contact avec, ladite couche (406) « d'interface », et destinée à former une source d'ions pour ledit électrolyte solide, ledit dispositif étant **caractérisé en ce que** ledit matériau donné est du carbone ou du carbone comportant un additif métallique ou un additif semi-conducteur.

7. Dispositif microélectronique selon la revendication 6, ladite couche d'interface (406) ayant une épaisseur comprise entre 1 et 10 nanomètres.

8. Dispositif microélectronique selon l'une des revendications 6 ou 7, ladite couche métallique (407) « donneuse d'ions » appartenant à ladite deuxième électrode.

9. Dispositif microélectronique selon l'une des revendications 6 ou 7, ladite deuxième électrode (408) reposant sur ladite couche métallique (407) « donneuse d'ions ».

10. Mémoire comprenant un dispositif microélectronique selon l'une des revendications 6 à 9.

## Claims

1. Method for making a microelectronic device provided with one or several cells or elements comprising at least one first electrode, at least one second electrode, and at least one thin layer that can form a solid electrolyte between the first electrode and the second electrode, the method comprising steps to:
a) make at least one doped chalcogenide layer (405) that will form said solid electrolyte, on at least one first conducting layer (402) that will form said first electrode,
b) form at least one layer called the "interface" layer (406), based on a given material different from said chalcogenide, on and in contact with the doped chalcogenide layer (405), said given material of the interface layer being carbon or carbon with a metallic additive such as silver, or a semi conducting addictive,
c) form at least one metallic layer (407) called the "ion donor" layer that is intended to form an ion source for said solid electrolyse, on and in contact with the interface layer.

2. Method as claimed in claim 1, said interface layer (406) being between 1 and 10 nanometers thick.

3. Method has claimed in claim 1 or 2, said metallic "ion donor" layer (407) and/or said interface layer (406) being formed by cathode sputtering.

4. Method as claimed in one of claims 1 to 3, formation of said doped chalcogenide layer (405) comprising:
- deposition of at least one layer (403) based on at least one chalcogenide,
- deposition by cathode sputtering of a thin metallic layer (405) on said chalcogenide layer.

5. Method as claimed in one of claims 1 to 4, also comprising formation of the second electrode (408) based on a metallic material different from that making up said metallic ion donor layer (407), on and in contact with the metallic ion donor layer (407).

6. Microelectronic device provided with one or several cells or elements comprising at least one first electrode, at least one second electrode, and at least one stack of thin layers between the first electrode and the second electrode, said stack comprising:
- at least one doped chalcogenide layer (405) capable of forming a solid electrolyte on and in contact with the first electrode (404),
- at least one so-called «interface» layer, on and in contact with said doped chalcogenide layer (405) and based on a given material different from said chalcogenide, said given material being carbon or carbon comprising a metallic additive or a semi conducting additive,
- at least one so-called metallic «ion donor» layer (407) on and in contact with said «interface» layer (406) and that is intended to form an ion source for said solid electrolyte.

7. Microelectronic device as claimed in claim 6, said interface layer (406) being of between 1 and 10 nanometers tick.

8. Microelectronic device as claimed in claim 6 or 7, said metallic "ion donor" (407) layer belonging to said second electrode.

9. Microelectronic device as claimed in claim 6 or 7, said second electrode (408) being supported on said metallic "ion donor" layer (407).

10. Memory comprising a microelectronic device as claimed in one of claims 6 to 9.

## Patentansprüche

1. Verfahren zur Herstellung eines mikroelektronischen Bauteils, das mit einer oder mehreren Zellen oder Elementen ausgestattet ist, die jeweils wenigstens eine erste Elektrode, wenigstens eine zweite Elektrode und wenigstens eine dünne Schicht umfassen, die einen festen Elektrolyten zwischen der ersten und der zweiten Elektrode zu bilden vermag, wobei das Verfahren die folgenden Schritte umfasst:
a) Herstellen auf wenigstens einer ersten leitfähigen Schicht (402), die zum Bilden der ersten Elektrode bestimmt ist, wenigstens einer dotierten Chalkogenidschicht (405), die zum Bilden des festen Elektrolyten bestimmt ist,
b) Bilden auf und im Kontakt mit der dotierten Chalkogenidschicht (405) wenigstens einer Grenzschicht genannten Schicht (406) auf der Grundlage eines gegebenen, von diesem Chalkogenid verschiedenen Materials,
c) Bilden auf und im Kontakt mit der Grenzschicht (406) wenigstens einer "Ionendonor" genannten metallischen Schicht (407), die zum Bilden einer Ionenquelle für den festen Elektrolyten bestimmt ist,
wobei das Verfahren **dadurch gekennzeichnet ist, dass** das gegebene Material der Grenzschicht Kohlenstoff oder Kohlenstoff mit einem metallischen oder halbleitenden Additiv ist.

2. Verfahren gemäß Anspruch 1, wobei die Grenzschicht (406) eine Dicke zwischen 1 und 10 Nanometer aufweist.

3. Verfahren gemäß Anspruch 1 oder 2, wobei die metallische "lonendonor"-Schicht (407) und/oder die Grenzschicht (406) durch Kathodenzerstäubung gebildet werden.

4. Verfahren gemäß einem der Ansprüche 1 bis 3, wobei das Bilden der dotierten Chalkogenidschicht (405)
- das Aufbringen wenigstens einer Schicht (403) auf der Grundlage wenigstens eines Chalkogenids und
- das Aufbringen einer dünnen metallischen Schicht (405) auf die Chalkogenidschicht durch Kathodenzerstäubung umfasst.

5. Verfahren gemäß einem der Ansprüche 1 bis 4, das außerdem das Bilden der zweiten Elektrode (408) auf der Grundlage eines von dem der metallischen lonendonorschicht (407) verschiedenen metallischen Materials auf und im Kontakt mit der metallischen lonendonorschicht (407) umfasst.

6. Mikroelektronisches Bauteil, das mit einer oder mehreren Zellen oder Elementen ausgestattet ist, die jeweils wenigstens eine erste Elektrode, wenigstens eine zweite Elektrode und wenigstens einen Stapel dünner Schichten zwischen der ersten und zweiten Elektrode umfassen, wobei der Stapel
- wenigstens eine dotierte Chalkogenidschicht (405), die einen festen Elektrolyten zu bilden vermag, auf und im Kontakt mit der ersten Elektrode (404),
- wenigstens eine "Grenzschicht" genannte Schicht (406) auf und im Kontakt mit der Chalkogenidschicht (405) und auf der Grundlage eines gegebenen, von diesem Chalkogenid verschiedenen Materials und
- wenigstens eine "Ionendonor" genannte metallische Schicht (407) auf und im Kontakt mit der "Grenzschicht" (406) umfasst, die zum Bilden einer Ionenquelle für den festen Elektrolyten bestimmt ist, wobei das Bauteil **dadurch gekennzeichnet ist, dass** das gegebene Material Kohlenstoff oder Kohlenstoff mit einem metallischen Additiv oder einem halbleitenden Additiv ist.

7. Mikroelektronisches Bauteil gemäß Anspruch 6, wobei die Grenzschicht (406) eine Dicke zwischen 1 und 10 Nanometer aufweist.

8. Mikroelektronisches Bauteil gemäß einem der Ansprüche 6 oder 7, wobei die metallische "lonendonor"-Schicht (407) der zweiten Elektrode angehört.

9. Mikroelektronisches Bauteil gemäß einem der Ansprüche 6 und 7, wobei die zweite Elektrode (408) auf der metallischen "lonendono"-Schicht (407) ruht.

10. Speicher umfassend ein mikroelektronisches Bauteil gemäß einem der Ansprüche 6 bis 9.
